(19)

Europäisches
Patentamt
European
Patent Office
Office européen
des brevets

(11) **EP 2 683 080 A1**

(12) **EUROPEAN PATENT APPLICATION**

(43) Date of publication:
**08.01.2014 Bulletin 2014/02**

(51) Int Cl.:
***H03F 3/45*** (2006.01)

(21) Application number: **12175265.3**

(22) Date of filing: **06.07.2012**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **NXP B.V.
5656 AG Eindhoven (NL)**

(72) Inventor: **Pruvost, Xavier
Redhill, Surrey RH1 1NY (GB)**

(74) Representative: **Miles, John Richard
NXP B.V.
Intellectual Property & Licensing
Red Central
60 High Street
Redhill, Surrey RH1 1SH (GB)**

(54) **Operational transconductance amplifier**

(57)     An OTA amplifier has a pair of cross coupled branches, in which current is injected into each branch, at the node between a pair of transistors in the branch, thereby to improve the linearity of the voltage to current conversion function of the amplifier.

FIG. 4

**Description**

The present invention relates generally to an OTA (operational transconductance amplifier) structure.

An OTA is an amplifier which produces an output current from a differential input voltage. Thus, it functions as a voltage controlled current source. OTAs are typically used to make amplifiers and filters in band ranging from 0 to 100MHz.

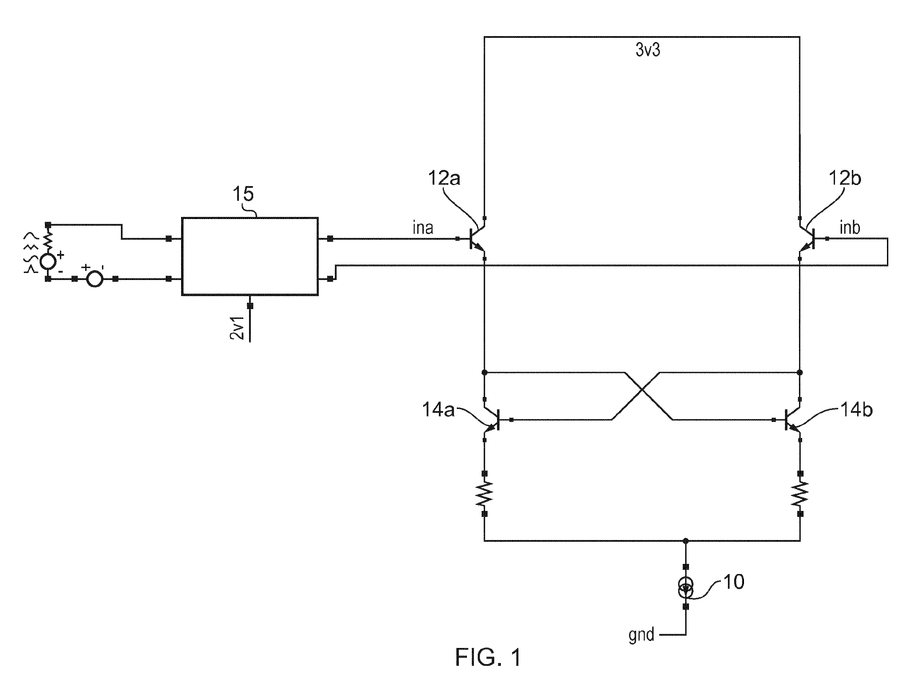

Figure 1 shows an example of a basic OTA core structure. It comprises four bipolar junction transistors. The transistors are in two parallel branches between a high power rail and current source tail 10. This current source 10 sets an amplifier dc bias current, which sets the overall transconductance of the amplifier.

Each branch comprises two series transistors 12, 14 (for one branch the transistors are shown as 12a,14a and for the other branch they are shown as 12b,14b). By series is meant that the collector-emitter path of one is in series with the collector-emitter path of the other. The top transistors 12a,12b have their collectors connected to the top power rail (3.3V for example), and their emitters connected to the collectors of the bottom transistors 14a,14b. This is what is meant by a series connection. The node in each branch between the two transistors defines a current output port, so that there is a differential current output.

The differential voltage input signal is applied across the gates of the top transistors 12a,12b, and the bottom transistors 14a,14b have cross-connected bases. The base of one connects to the collector of the other. A tail resistor is shown present between each lower transistor 14 and the current source, although in practice, this resistor is an intrinsic resistance of the bottom transistor 14.

This structure gives a high linearity thanks to the cross connected bottom transistors 14. A converter 15 converts the input voltage into a differential voltage with a dc reference, for example 2.1V.

Note that Figure 1 is a simplified schematic diagram of the typical configuration. For example current mirrors are typically used to deliver output current.

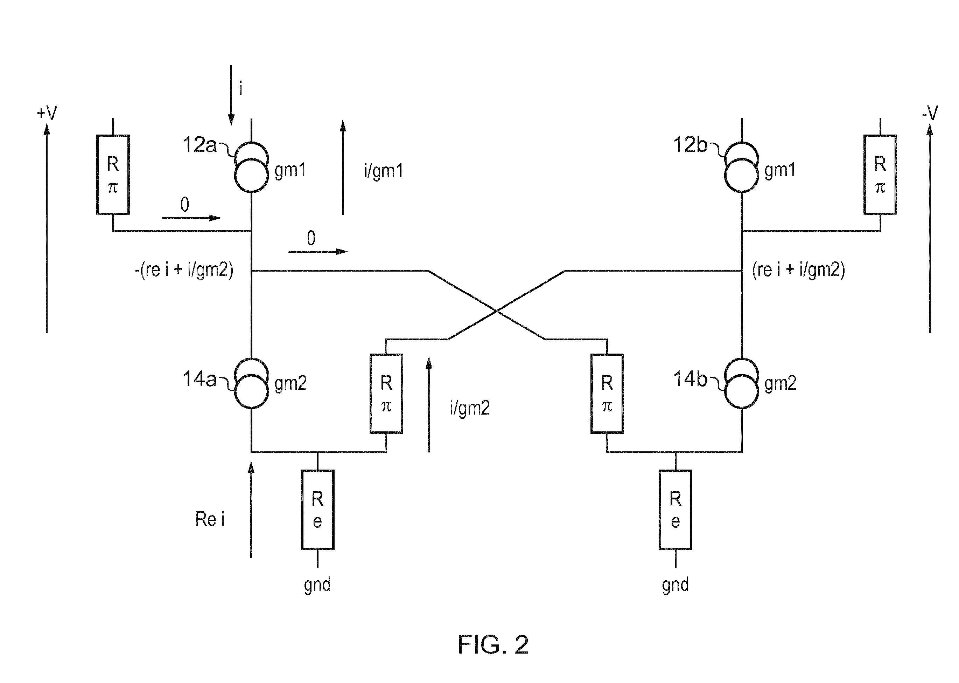

Figure 2 shows a small signal equivalent circuit for the OTA core. Each transistor is represented as a current source, and the corresponding transconductance gm is shown (gm1 for the top transistors and gm2 for the bottom transistors). The differential input voltage is shown as +V and -V, and the output current is shown as I, which flows down one branch of the amplifier core. This is the small signal current.

The base resistances are shown as $R\pi$ and the emitter resistances are shown as Re. Figure 2 shows the voltages at the nodes between the two transistors of each branch, as well as across some of the resistors.

The transconductance value gm is defined as:

$$gm = \Delta icollector / \Delta vbase$$

For small signals:

$$gm = icollector / vbase$$

Hence

$$vbase = icollector / gm$$

The current can considered as zero based on the value of $R\pi$ being very high.

The circuit of Figure 2 gives a small signal equivalent of circuit of Figure 1. The transistors are replaced by their small signal equivalent model. For transistor 14a for example the collector voltage =-(rei+i/gm2) and the base voltage=rei+i/gm2.

The circuit of Figure 2 yields:

$$V = -\operatorname{Re} i - \frac{i}{gm_2} + \frac{i}{gm_1} = -\operatorname{Re} i - i.\left(\frac{1}{gm_2} - \frac{1}{gm_1}\right)$$

Note that an equal and opposite small signal current flows through the two branches.

With $gm_1 = gm_2$ (because the same collector current is in transistors 1 and 2):

$$Gm_{tot} = \frac{i}{V} = -\frac{1}{\text{Re}}$$

In conclusion, the overall effective transconductance $Gm_{tot}$ is only a function of Re, therefore the OTA is very linear. In this ideal schematic, non linear gm1 and gm2 terms cancel each other.

Unfortunately, the current in the resistors R$\pi$ cannot be neglected.

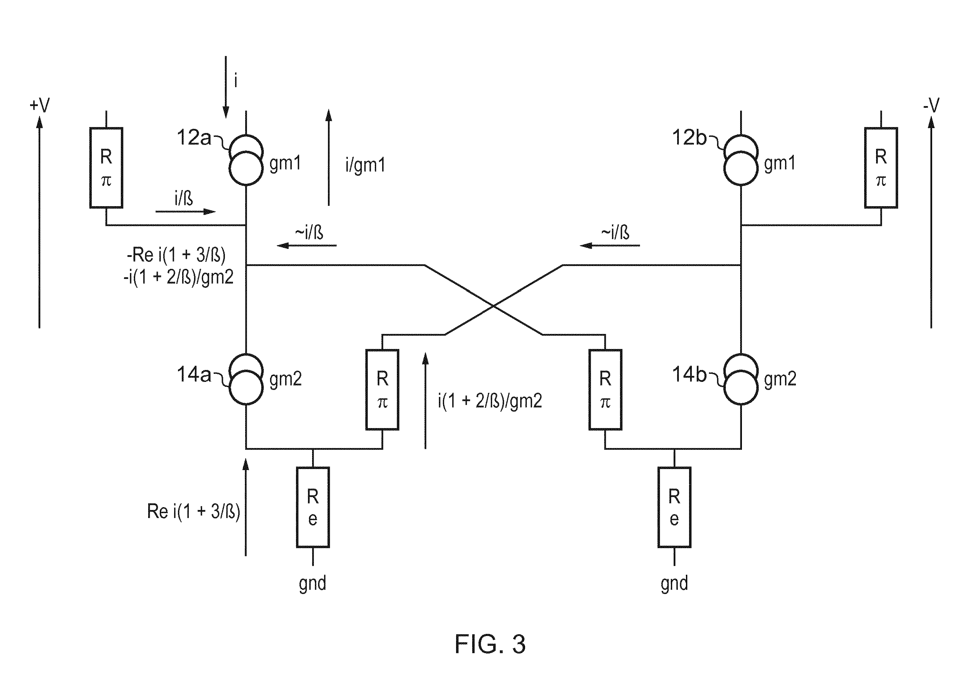

Figure 3 shows a small signal equivalent circuit of the OTA core with base currents. These are shown as a fraction $1/\beta$ of the output current i (where $\beta$ is the ratio of collector current to base current). It is assumed that $R\pi_1$ *gm1=R$\pi$2*gm2= $\beta$, based on all four transistors being identical.

From Figure 3:

$$V = -\text{Re}.i.(1+\frac{3}{\beta}) - \frac{i}{gm_2}(1+\frac{2}{\beta}) + \frac{i}{gm_1}$$

$$\frac{V}{i} = -\text{Re}.(1+\frac{3}{\beta}) + \frac{1}{gm_1} - \frac{(1+\frac{2}{\beta})}{gm_2}$$

V/i is not linear because it is dependant on gm1 and gm2. This is a limitation of existing OTA structures, and it results in non-linear behaviour. There is therefore a need for an OTA with improved linearity.

According to the invention, there is provided an OTA amplifier, comprising:

a first branch having first and second transistors in series between high and low power rails and connected together at a first node;

a second branch having first and second transistors in series between the high and low power rails and connected together at a second node;

a pair of input lines connected to the control terminals of the first transistors, for receiving a differential voltage as input to the amplifier; and

a current output arrangement which provides an output current dependent on the currents flowing in the first and second branches,

wherein the control terminal of the second transistor in the first branch is connected to the second node and the control terminal of the second transistor in the second branch is connected to the first node,

and wherein a current source is provided for injecting a current to each of the first and second nodes.

The invention relates to OTA amplifiers using cross-coupled transistor pairs, and relates particularly to bipolar junction transistors.

The addition of these injection currents improves the linearity of the amplifier, in particular the voltage to current conversion function of the amplifier. The linearity of the voltage to current conversion can in this way be set to an optimum.

By "in series" in connection with transistors is meant that output paths are in series, in which the control terminal is the input and the two other terminals define the output path. In the case of bipolar junction transistors, the output terminals are the collector and emitter and the input terminal is the base. In this case, the collector of one is connected to the emitter of the next in a series arrangement.

A first output current mirror circuit can be provided for generating a first current output from the amplifier derived from the current flowing through the second transistor of one of the branches, and a second output current mirror circuit can be provided for generating a second current output from the amplifier derived from the current flowing through the second transistor of the other one of the branches.

Thus, the output current provided by the OTA is a differential output current provided by the two current mirror circuits. This enables an output current to be derived from the internal currents flowing within the core of the OTA, and without disrupting the operation of the OTA core.

A current mirror arrangement is preferably provided for generating the injection current from a transistor control current (i.e. a transistor base current in the case of a bipolar junction transistor). In this way, the injection current is proportional to the transistor control (i.e. base) current.

The operating point (defined by the collector current) is rather stable with regard to process change, but base currents are not that stable. Base currents have significant process spread. The injection current is thus fixed with reference to the base current to cope with β process spread.

The current mirror arrangement (for the injection current) can comprise a first current mirror circuit for mirroring an OTA bias current, and driving the mirrored current through a reference transistor of the same type as the first and second transistors. In this way, a reference transistor is biased in a way that is related to the bias of the main transistors used in the circuit. A second current mirror circuit is for generating the injection current from a control current of the reference transistor. This means the control (base or gate) current of the main transistors used in the circuit is essentially duplicated and monitored in order to derive the injection current. The injection current thus depends on the operating point of the amplifier.

The (second) current mirror circuit can then generate the injection current as a multiple of the reference transistor control current.

The first and second transistors of each branch (and the reference transistor) preferably comprise bipolar junction transistors.

The invention also provides a method of controlling an OTA amplifier which comprises:

a first branch having first and second transistors in series between high and low power rails and connected together at a first node;
a second branch having first and second transistors in series between the high and low power rails and connected together at a second node;
a pair of input lines connected to the control terminals of the first transistors, for receiving a differential voltage as input to the amplifier; and
a current output arrangement which provides an output current dependent on the currents flowing in the first and second branches,
wherein the control terminal of the second transistor in the first branch is connected to the second node and the control terminal of the second transistor in the second branch is connected to the first node,
wherein the method comprises injecting a current to each of the first and second nodes.

This method improves the linearity of the voltage to current conversion function of the amplifier.

Examples of the invention will now be described in detail with reference to the accompanying drawings, in which:

Figure 1 shows the core of a known OTA amplifier circuit;
Figure 2 shows an equivalent circuit for the circuit of Figure 1 assuming zero base current;
Figure 3 shows an equivalent circuit for the circuit of Figure 1 with non-zero base currents;
Figure 4 shows in simplified form an example of amplifier circuit of the invention;
Figure 5 shows a simulation of the performance of the circuit of Figure 4
Figure 6 shows the circuit of Figure 4 with some additional circuit components, in particular current mirrors used to deliver output current;
Figure 7 shows an equivalent circuit for the circuit of Figure 6 with non-zero base currents;
Figure 8 shows a known OTA circuit in more detail;
Figure 9 shows the invention applied to the circuit of Figure 8;
Figure 10 shows linearity of an amplifier using the circuit of Figure 8, the amplifier comprising an OTA cell combined with a resistive feedback network; and
Figure 11 shows linearity of an amplifier using the circuit of Figure 9, again with the amplifier comprising an OTA cell combined with a resistive feedback network.

The invention provides an OTA amplifier having a pair of cross coupled branches, in which current is injected into each branch, at the node between the pair of transistors in the branch, thereby to improve the linearity of the voltage to current conversion function of the amplifier.

As shown above, the ratio between voltage and current for the conventional OTA is given by:

$$\frac{V}{i} = -\mathrm{Re}.(1+\frac{3}{\beta}) + \frac{1}{gm_1} - \frac{(1+\frac{2}{\beta})}{gm_2}$$

The invention aims to target the nonlinear parts of the relation, namely to set:

$$-\frac{(1+\frac{2}{\beta})}{gm_2} + \frac{1}{gm_1} = 0$$

By doing this, the V/I relation can be made as linear as possible.

This target is obtained when:

$$gm_2 = gm_1\left(1+\frac{2}{\beta}\right) \Leftrightarrow Ic_2 = Ic_1 + 2ib_1$$

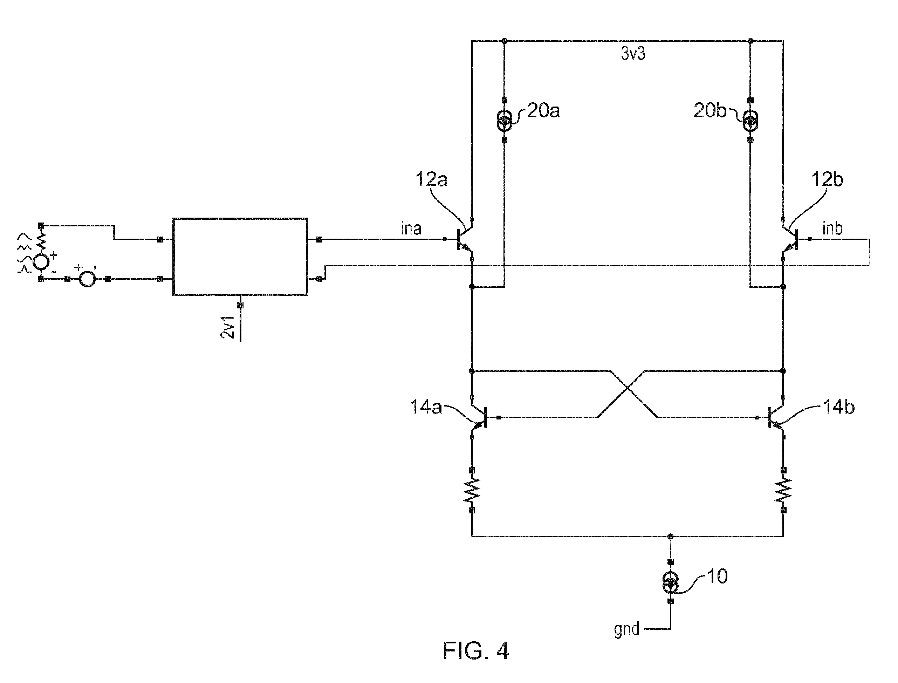

It is possible to achieve this by adding dc sources delivering a current Iadjust as shown in Figure 4.

Figure 4 differs from Figure 1 in that each top transistor 12a,12b has a current source 20a,20b between its collector and emitter providing the current Iadjust. This current is thus supplied to the nodes between the transistors in the two branches.

These current sources achieve Ic1=Ic2 - $\Delta$, namely they make the two collector currents slightly different.

The effect of the current sources has been determined by simulation. The core cell has been simulated choosing i=200$\mu$A and Re=3$\Omega$.

Iadjust is changed gradually and a transconductance value Gmt is as well as the third order output intercept point (OPI3) are monitored.

The value Gmt is a "total" transconductance value which is defined as:

$$Gmt=Ic_{(12a)}/(Vb_{(12a)}- Vb_{(12b)})$$

Where $Ic_{(12a)}$ is the collector current of the transistor 12a, $Vb_{(12a)}$ is the base current of the transistor 12a, and $Vb_{(12b)}$ is the base current of the transistor 12b.

A parametric simulation has been performed with various values applied for Iadjust. An ac plot is made at frequency 10MHz, which is chosen because it is in the upper part of an example of band of interest for low IF applications.

Tones at 8MHz and 9MHz are used to stimulate the OTA and the output current is referenced to 200$\mu$A peak.

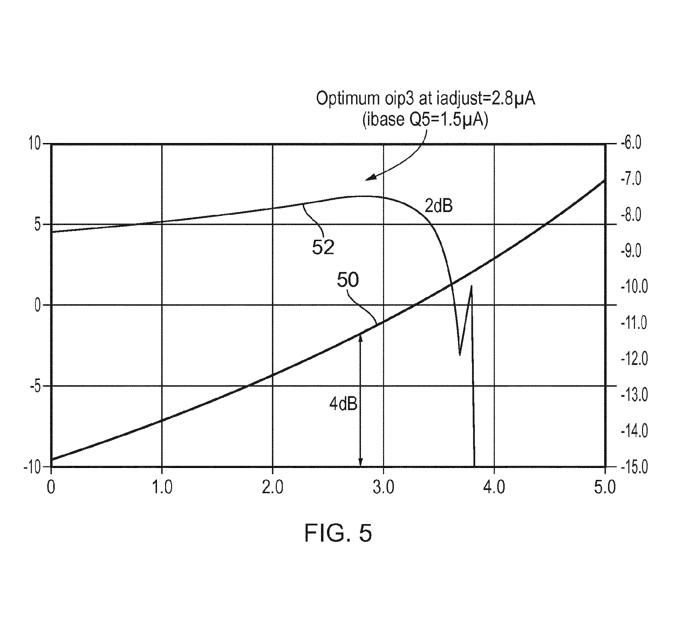

The results are presented in Figure 5 which is a linearity and gain simulation for the OTA core results with respect to the adjustment current Iadjust.

Plot 50 is the gain and plot 52 is the third order output intercept point (OPI3).

The OIP3 measure has an optimum at iadjust=2 ibase (2.8≈2x1.5), wherein ibase is the base current to the transistor 14a.

The base current is roughly the same to all four transistors because they are identical and have (almost) the same collector current. Nevertheless, the base current can change with process variation, which is why it is valuable to to check behaviour with a Monte-Carlo simulation.

The OIP3 value is improved by 2dB. The value of Gmt at 10MHz is also increased by 4dB. This is beneficial when the OTA is used in a closed loop.

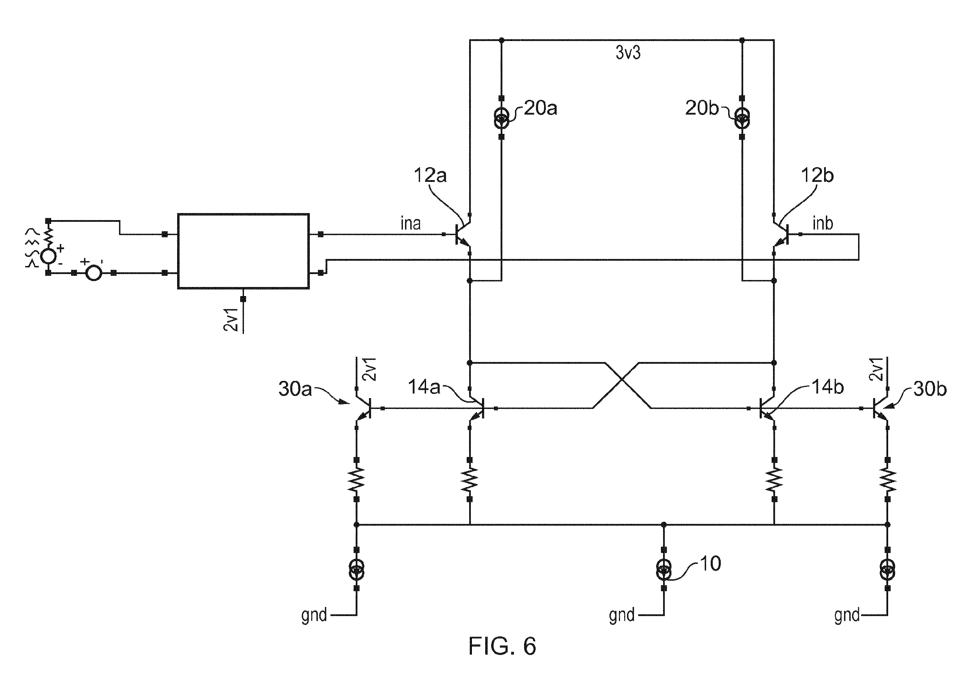

Figure 6 shows that in a real circuit, the bottom transistors have current mirrors 30a,30b. The current mirrors are used to deliver the OTA output current to the output load (not shown). They enable an output current with large voltage swing capability. They also provide a way to boost the value Gmt because the current mirrors provide a multiplying factor.

The current mirrors 30a,30b together form a current output arrangement. This output arrangement provides an output current which is dependent on the currents flowing in the first and second branches, in particular a scaled version of the branch currents. Thus, the OTA core has branch currents which are modulated by the differential voltage applied, and these branch currents are the required outputs from the circuit. The current output arrangement uses current mirrors to generate the OTA outputs as a pair of differential currents.

As shown, the first output current mirror circuit 30a is for generating a first current output from the amplifier derived from the current flowing through the second transistor 14a, and the second output current mirror circuit 30b is for generating a second current output from the amplifier derived from the current flowing through the second transistor 14b. In this way, the operation of the OTA core is separate from the differential output current provided by the two current mirror circuits 30a, 30b.

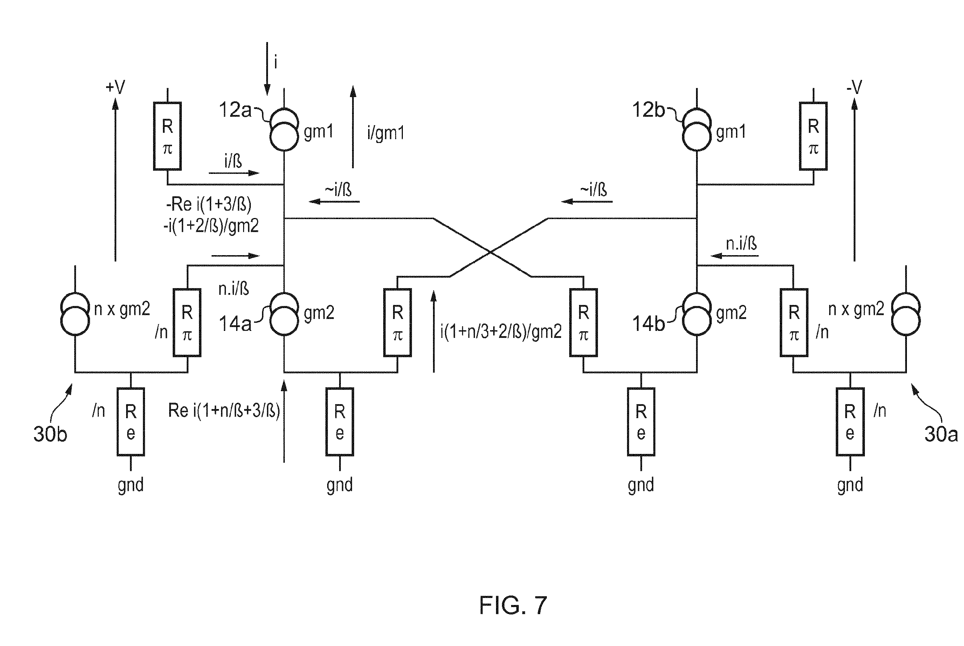

Using same approach as above, an equivalent circuit for Figure 6 is shown in Figure 7.

Note that in Figure 7, by using identical transistors, R1gm1=R2gm2=β.

Note that the dc current sources 20a, 20b are not shown in Figure 7 as they are dc sources and therefore do not appear in the small ac signal schematic circuit.

In Figure 7, n is the current mirror multiplying factor for the output current mirror circuits 30a, 30b. It corresponds to the ratio between the transistor 14a/14b and the transistor of the current mirror 30a/30b in Figure 6, for example with a value of 5.

V/I can be estimated as follows

$$V = -\frac{i}{gm_2}(1 + \frac{n}{\beta} + \frac{2}{\beta}) - \mathrm{Re}.i.(1 + \frac{n}{\beta} + \frac{3}{\beta}) + \frac{i}{gm_1}$$

$$\frac{V}{i} = -\mathrm{Re}.(1 + \frac{n}{\beta} + \frac{3}{\beta}) - \frac{1}{gm_2}(1 + \frac{n}{\beta} + \frac{2}{\beta}) + \frac{1}{gm_1}$$

Then the aim is to target:

$$\frac{gm_2}{gm_1} = (1 + \frac{n}{\beta} + \frac{2}{\beta})$$

$$\Leftrightarrow\ Ic_2 = (1 + \frac{n}{\beta} + \frac{2}{\beta})Ic_1 = Ic_1 + nIb1 + 2Ib1$$

From this it follows that:

$$Ic_1 + Iadjust = Ic2 + nIb2$$

Thus, it can be deduced that:

$$Iadjust = nIb1 + 2Ib1 + nIb2 \cong 2.(n+1).Ibase \cong 2Ibase\_tot$$

Ib1 and Ib2 are the base currents for the top and bottom transistors respectively. They are assumed to be equal in the approximation above, i.e. Ib1=Ib2=Ibase. Ibase_tot is the sum of base current of the top/bottom transistor 12a, 14a (Ibase) and the base currents of the current mirror 30a (see Figure 6), since the current mirror ratio is n.

Thus, the injection current required is approximately double a total base current. With a current mirror output, as in the equations above, the injection current is the multiple of the combined base currents of one of the current mirrors and one of the OTA core transistors.

Since the required injection current is simply a multiple of the base current of one of the OTA core transistors (the multiple depending on the output current mirror ratio), the injections currents can be derived from a base current flowing through a reference transistor, as explained below.

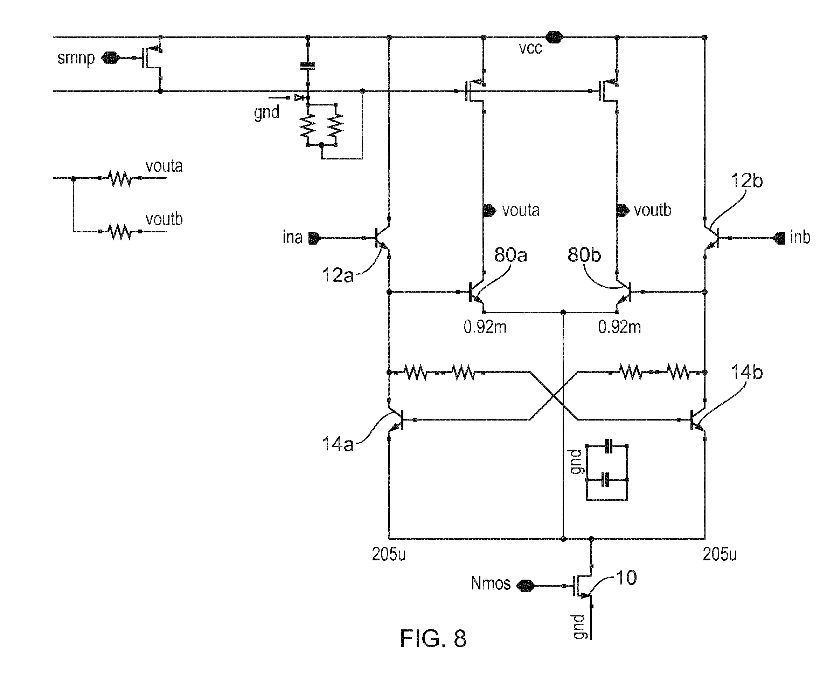

Figure 8 shows in more detail an example of a known OTA circuit, which will be used to show how the circuit can be modified to implement the invention. Other circuit implementations are possible, which can also be modified to provide the current injection of the invention.

The main difference with the core schematic of Figure 1 is the addition of transistors 80a and 80b which are used to copy currents. Transistor 80a makes a copy of the current through bottom transistor 14b because both transistors have the same base emitter voltage. The voltage drop in resistors is neglected. The copy factor is the ratio of emitter length, and can be roughly 5. Transistor 80b makes a copy of the current through bottom transistor 14a. Thus, the transistors 80,80b function as the current mirror output circuits.

The added transistors 80a and 80b are used to deliver the output current through output pins vouta and voutb. Note that while the output of the circuit is a current, it can be converted into a voltage by an external feedback loop. This is why the output terminals are labelled vouta/voutb.

As explained above, one implementation of the invention is to set $I_{adjust} \cong 2ibase_{tot}$

This assumes Ib1 is approximately equal to Ib2.

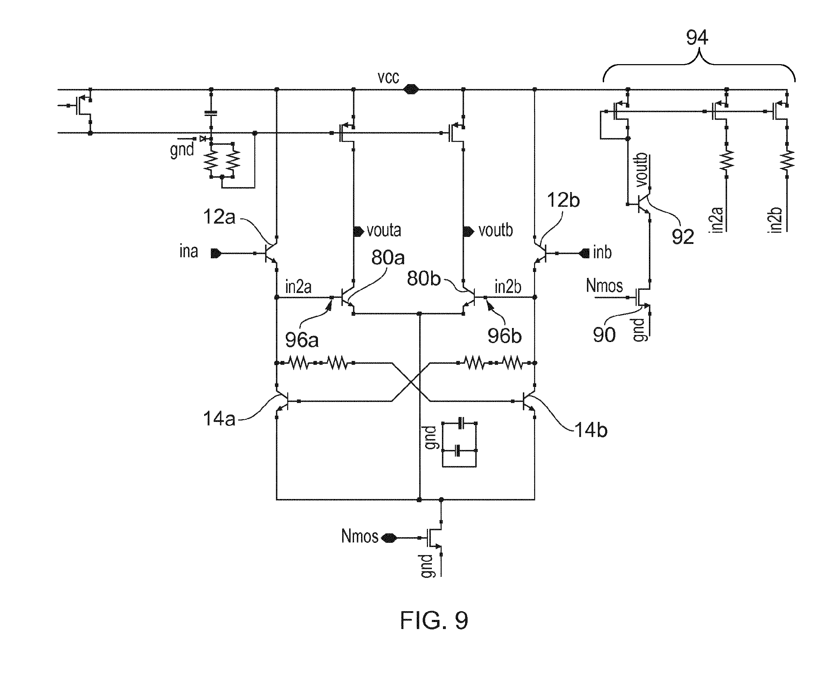

Figure 9 shows how to implement the invention as a modification to the circuit of Figure 8, and without increasing the total current.

The bias current (for example initially 2.25mA) is typically made by a bank of, for example, 16 MOS transistors in parallel in the circuit of Figure 8. These transistors define the dc bias current source 10.

In one implementation of the invention, one MOS 90 among the 16 is removed and used instead in a new branch as shown in Figure 9. This MOS 90 thus functions as a current mirror circuit, since it is biased in the same way as the remaining 15 transistors of the bias current source. Thus, it mirrors the current through each of the 15 transistors of the bias current source. Of course, this mirror function does not have to be 1:1 to the individual transistors of the current source 10. Similarly, a number 15 of transistors to form the tail current source is arbitrary. Essentially, the arrangement provides a current through the reference transistor 92 which is dependent on the dc bias current flowing through the transistors 14a,14b.

The total current used by the circuit is still the same but now, a fraction (1/16) is used to generate a current to be driven through a reference transistor. Thus, in this example, the current is approximately 1/15 of bias current.

The copied current flows through a reference bipolar junction transistor 92, and this results in a particular base current of the transistor 92. This base current is used by a current mirror 94 with a suitable mirror ratio to generate the two adjustment currents Iadjust, which are provided to nodes 96a,96b (as shown in Figure 4).

Thus, a multiplying mirror 94 is used to scale up the monitored base current of transistor 92 in order to generate the adjustment currents to be fed back into the OTA core. The mirror ratio can for example be around 10 - 15 (for the value n=5 given above).

The multiplying ratio of the current mirror 94 is selected taking into account the output current mirror multiplier ratio (n) as well as the relationship between the base current of the transistor 92 and the transistors 12a,12b,14a,14b to provide the required adjustment current. This adjustment current is dependent on the characteristics of the transistor 92 including the value β. This transistor itself represents the base current characteristics of the main transistors 12a, 12b,14a,14b of the OTA core.

The modified OTA can be used with feedback resistors to make a simple amplifier.

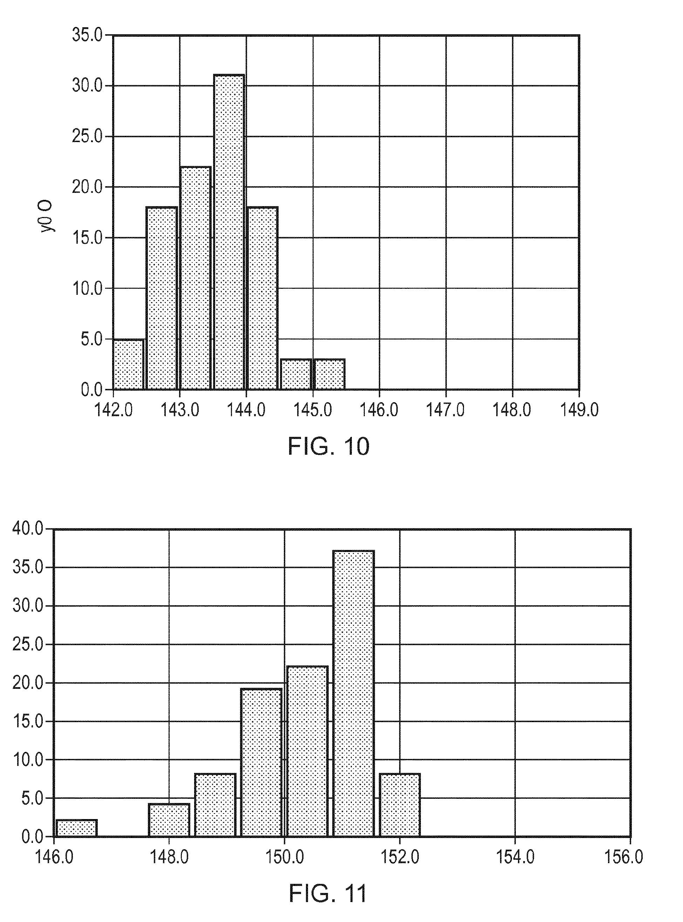

Figures 10 and 11 show OIP3 results with this simple amplifier. Figure 10 gives the value of OIP3 for the circuit of Figure 8 and Figure 11 gives the value of OIP3 for the circuit of Figure 9. The value of OIP3 is expressed in dBμV rms.

In Figures 10 and 11, the x axis is the OIP3 in dBμV. The y axis is the number of cases obtained by a Monte-Carlo statistical analysis.

The average OIP3 is improved by 7dB with this implementation of the invention, giving a huge improvement.

The invention can be applied generally to OTAs to improve linearity or keep the same linearity with less current in the filters and amplifiers.

For example the invention can be used in a RF receiver circuit, for example as part of a digital TV tuner circuit.

Only the OTA core has been described in detail above. It will be appreciated by those skilled in the art that other peripheral circuitry will be used in combination with the OTA core.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. Any reference signs in the claims should not be construed as limiting the scope.

**Claims**

1. An OTA amplifier, comprising:

   a first branch having first and second transistors (12a,14a) in series between high and low power rails and connected together at a first node (96a);
   a second branch having first and second transistors in series between the high and low power rails and connected together at a second node (96b);
   a pair of input lines connected to the control terminals of the first transistors (12a,12b), for receiving a differential voltage as input to the amplifier; and
   a current output arrangement which provides an output current dependent on the currents flowing in the first and second branches,
   wherein the control terminal of the second transistor (14a) in the first branch is connected to the second node (96b) and the control terminal of the second transistor (14b) in the second branch is connected to the first node (96a),
   and wherein a current source (90,92,94) is provided for injecting a current to each of the first and second nodes (20a,20b; 96a,96b).

2. An amplifier as claimed in claim 1, comprising a first output current mirror circuit (30a;80a) for generating a first current output from the amplifier derived from the current flowing through the second transistor (14a) of one of the branches, and a second output current mirror circuit (30b;80b) for generating a second current output from the amplifier derived from the current flowing through the second transistor (14b) of the other one of the branches.

3. An amplifier as claimed in claim 1, wherein the current source (90,92,94) comprises a current mirror arrangement for generating the injection current from a transistor control current.

4. An amplifier as claimed in claim 3, wherein the current mirror arrangement (90,92,94) comprises a first current mirror circuit (90) for mirroring an OTA bias current, and driving the mirrored current through a reference transistor (92) of the same type as the first and second transistors.

5. An amplifier as claimed in claim 4, wherein the current mirror arrangement comprises a second current mirror circuit (94) for generating the injection current from a control current of the reference transistor (92).

6. An amplifier as claimed in claim 5, wherein the second current mirror circuit (94) generates the injection current as a multiple of the reference transistor (92) control current.

7. An amplifier as claimed in any preceding claim, wherein the first and second transistors (12a,12b,14a,14b) of each branch comprise bipolar junction transistors.

8. An amplifier as claimed in claim 2 wherein the injection current comprises between 1.5 and 2.5 times the sum of the control current of the second transistor (14a,14b) in one of the first and second branches and the control current of the transistor of a corresponding one of the first and second output current mirror circuits (30a,30b; 80a,80b).

9. A receiver circuit comprising an OTA amplifier as claimed in any preceding claim.

10. A digital TV tuner comprises a receiver circuit as claimed in claim 9.

11. A method of controlling an OTA amplifier which comprises:

a first branch having first and second transistors (12a,14a) in series between high and low power rails and connected together at a first node (96a);

a second branch having first and second transistors (12b,14b) in series between the high and low power rails and connected together at a second node (96b);

a pair of input lines connected to the control terminals of the first transistors (12a,12b), for receiving a differential voltage as input to the amplifier; and

a current output arrangement which provides an output current dependent on the currents flowing in the first and second branches,

wherein the control terminal of the second transistor (14a) in the first branch is connected to the second node (96b) and the control terminal of the second transistor (14b) in the second branch is connected to the first node (96a),

wherein the method comprises injecting a current to each of the first and second nodes (96a,96b).

12. A method as claimed in claim 11, comprising generating the injection current from a transistor control current.

13. A method as claimed in claim 11, comprising using a first current mirror circuit (90) to mirror an OTA bias current, and driving the mirrored current through a reference transistor (92) of the same type as the first and second transistors (12a,12b,14a,14b).

14. A method as claimed in claim 13, comprising using a second current mirror circuit (94) to generate the injection current from a control current of the reference transistor (92).

15. A method as claimed in claim 14, comprising generating the injection current as a multiple of the reference transistor (92) control current.

FIG. 1

FIG. 2

EP 2 683 080 A1

FIG. 3

FIG. 4

FIG. 5

FIG. 6

FIG. 7

EP 2 683 080 A1

FIG. 8

EP 2 683 080 A1

FIG. 9

EP 2 683 080 A1

FIG. 10

FIG. 11

Europäisches
Patentamt
European
Patent Office
Office européen
des brevets

# EUROPEAN SEARCH REPORT

Application Number

EP 12 17 5265

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 910 164 A1 (NEC CORP [JP] NEC ELECTRONICS CORP [JP]) 21 April 1999 (1999-04-21) * paragraph [0055] - paragraph [0064]; figure 2 * * paragraph [0070] * | 1-14 | INV. H03F3/45 |
| X | US 6 249 184 B1 (CORSI MARCO [US]) 19 June 2001 (2001-06-19) * figure 2 * | 1,3,11, 12 | |
| A | HSUAN-YU MARCUS PAN ET AL: "An Improved Broadband High Linearity SiGe HBT Differential Amplifier", IEEE TRANSACTIONS ON CIRCUITS AND SYSTEMS I: REGULAR PAPERS, IEEE, US, vol. 58, no. 8, 1 August 2011 (2011-08-01) , pages 1685-1694, XP011336637, ISSN: 1549-8328, DOI: 10.1109/TCSI.2010.2103191 * the whole document * | 1-15 | |
| A | US 5 184 086 A (INOHANA HARUYUKI [JP] ET AL) 2 February 1993 (1993-02-02) * column 5, line 24 - column 6, line 2; figure 2 * | 1-15 | TECHNICAL FIELDS SEARCHED (IPC)  H03F |
| A | US 4 496 860 A (TOKUMO AKIO [JP]) 29 January 1985 (1985-01-29) * the whole document * | 1-15 | |
| A | US 5 606 288 A (PRENTICE JOHN S [US]) 25 February 1997 (1997-02-25) * the whole document * | 1-15 | |
| A | US 5 399 988 A (KNIERIM DANIEL G [US]) 21 March 1995 (1995-03-21) * the whole document * | 1-15 | |

-/--

The present search report has been drawn up for all claims

| Place of search | Date of completion of the search | Examiner |
|---|---|---|
| Munich | 21 January 2013 | Kurzbauer, Werner |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

**Application Number**

EP 12 17 5265

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 0 637 128 A1 (PHILIPS ELECTRONICS NV [NL]) 1 February 1995 (1995-02-01) * the whole document * | 1-15 | |
| A | WO 96/31948 A2 (PHILIPS ELECTRONICS NV [NL]; PHILIPS NORDEN AB [SE] PHILIPS ELECTRONIC) 10 October 1996 (1996-10-10) * the whole document * | 1,11 | |
| A | US 4 456 887 A (TOKUMO AKIO [JP]) 26 June 1984 (1984-06-26) * the whole document * | 1,11 | |
| A | JP 4 098683 A (TOSHIBA CORP; TOSHIBA MICRO ELECTRONICS) 31 March 1992 (1992-03-31) * abstract * | 1-15 | |

TECHNICAL FIELDS
SEARCHED      (IPC)

The present search report has been drawn up for all claims

| Place of search | Date of completion of the search | Examiner |
|---|---|---|
| Munich | 21 January 2013 | Kurzbauer, Werner |

EPO FORM 1503 03.82 (P04C01)

## ANNEX TO THE EUROPEAN SEARCH REPORT
## ON EUROPEAN PATENT APPLICATION NO.

EP 12 17 5265

This annex lists the patent family members relating to the patent documents cited in the above-mentioned European search report.
The members are as contained in the European Patent Office EDP file on
The European Patent Office is in no way liable for these particulars which are merely given for the purpose of information.

21-01-2013

| Patent document cited in search report | | Publication date | Patent family member(s) | | Publication date |
|---|---|---|---|---|---|
| EP 0910164 | A1 | 21-04-1999 | DE | 69824514 D1 | 22-07-2004 |
| | | | EP | 0910164 A1 | 21-04-1999 |
| | | | JP | 3119215 B2 | 18-12-2000 |
| | | | JP | 11122059 A | 30-04-1999 |
| | | | US | 6054897 A | 25-04-2000 |
| US 6249184 | B1 | 19-06-2001 | NONE | | |
| US 5184086 | A | 02-02-1993 | DE | 4140559 A1 | 24-12-1992 |
| | | | FR | 2677822 A1 | 18-12-1992 |
| | | | JP | 4369107 A | 21-12-1992 |
| | | | US | 5184086 A | 02-02-1993 |
| US 4496860 | A | 29-01-1985 | JP | 57160207 A | 02-10-1982 |
| | | | US | 4496860 A | 29-01-1985 |
| US 5606288 | A | 25-02-1997 | NONE | | |
| US 5399988 | A | 21-03-1995 | JP | 7254828 A | 03-10-1995 |
| | | | US | 5399988 A | 21-03-1995 |
| EP 0637128 | A1 | 01-02-1995 | BE | 1007434 A3 | 13-06-1995 |
| | | | DE | 69403739 D1 | 17-07-1997 |
| | | | DE | 69403739 T2 | 11-12-1997 |
| | | | EP | 0637128 A1 | 01-02-1995 |
| | | | JP | 7066643 A | 10-03-1995 |
| | | | US | 5463308 A | 31-10-1995 |
| WO 9631948 | A2 | 10-10-1996 | DE | 69616214 D1 | 29-11-2001 |
| | | | DE | 69616214 T2 | 27-06-2002 |
| | | | EP | 0761037 A1 | 12-03-1997 |
| | | | JP | H10501115 A | 27-01-1998 |
| | | | US | 5742248 A | 21-04-1998 |
| | | | WO | 9631948 A2 | 10-10-1996 |
| US 4456887 | A | 26-06-1984 | DE | 3138078 A1 | 27-05-1982 |
| | | | US | 4456887 A | 26-06-1984 |
| JP 4098683 | A | 31-03-1992 | NONE | | |

EPO FORM P0459

For more details about this annex : see Official Journal of the European Patent Office, No. 12/82